# EUROPEAN PATENT APPLICATION

(11) **EP 2 378 851 A2**
(43) Date of publication of application: **19.10.2011**
(21) Application number: 10187442.8
(22) Date of filing: 13.10.2010
(51) Int. Cl.: H05K 9/00

(54) **Electromagnetic shielding enclosure and electronic apparatus having same**

(30) Priority: 19.04.2010 CN 201010150245
(71) Applicant: Hong Fu Jin Precision Industry (ShenZhen) Co., Ltd., Longhua Town, Bao'an District Shenzhen City Guangdong 518109 (CN); Hon Hai Precision Industry Co., Ltd., Tu-cheng City, Taipei Hsien (TW)
(72) Inventor: Li, Xiao-Yan, Bao'an District 518109, Shenzhen City (CN); Peng, Yao-Che, Tu-chen City (TW)
(74) Representative: Wilson, Peter

(57) **Abstract**

An electromagnetic shielding enclosure (100) includes a main body (30) for enclosing a mounting region (204) of a printed circuit board (20), a plurality of fixing fins (303), and a number of resilient fins (304). The fixing fins (303) and the resilient fins (304) extend out from edges of the main body (30). Each of the resilient fins (304) has a protrusion (305) formed thereon. The fixing fins (303) are configured for being fixedly attached the main body (30) on the printed circuit board (20) in a manner that ensures the main body (30) encloses the mounting region (204) and the protrusions (305) resiliently contact with a grounding region (203) of the printed circuit board (20).

## Description

### BACKGROUND

### 1. Technical Field

The present disclosure relates to electromagnetic shielding enclosure, and particularly, to an electromagnetic shielding enclosure having a plurality of contact protrusions and a related electronic apparatus.

### 2. Description of Related Art

It is thought that exposure to acute electromagnetic radiation may have undesirable effects on human health. For purpose of decreasing people's exposure to electromagnetic radiation, electronic apparatus, such as cell phones, computers, and digital cameras, generally employ electromagnetic shielding enclosures for enclosing electronic components packaged on a printed circuit board (PCB). The electromagnetic shielding enclosure is usually mounted on the PCB and electrically connected with grounding regions of the PCB. However, grounding regions of PCBs may not be smooth enough to form a good seal with the electromagnetic shielding enclosure. As a result, the electromagnetic shielding enclosure cannot be properly grounded, which decreases electromagnetic shield efficacy. Therefore, an electromagnetic shielding enclosure and a related electronic apparatus are desired for overcoming the shortcomings as aforementioned.

### SUMMARY

According to an exemplary embodiment, an electromagnetic shielding enclosure includes a main body for enclosing a mounting region of a printed circuit board, a plurality of fixing fins, and a number of resilient fins. The fixing fins and the resilient fins extend out from edges of the main body. Each of the resilient fins has a protrusion formed thereon. The fixing fins are configured for being fixedly attached the main body on the printed circuit board in a manner that ensures the main body encloses the mounting region and the protrusions resiliently contact with a grounding region of the printed circuit board.

### BRIEF DESCRIPTION OF THE DRAWINGS

Many aspects of the present enclosure and the electronic apparatus can be better understood with reference to the following drawings. The components in the drawings are not necessarily drawn to scale, the emphasis instead being placed upon clearly illustrating the principles of the presentment enclosure and the apparatus. Moreover, in the drawings, like reference numerals designate corresponding parts throughout the views.

FIG. 1 is an isometric, cutaway view of an electronic apparatus in accordance with an exemplary embodiment, the electronic apparatus includes an electronic module having a PCB and an electromagnetic shielding enclosure.

FIG. 2 is an isometric, exploded view of the electronic module of FIG. 1.

FIG. 3 is an isometric, assembled view of the electronic module.

FIG. 4 is an isometric view of a circled portion IV of the electronic module of FIG. 1.

### DETAILED DESCRIPTION

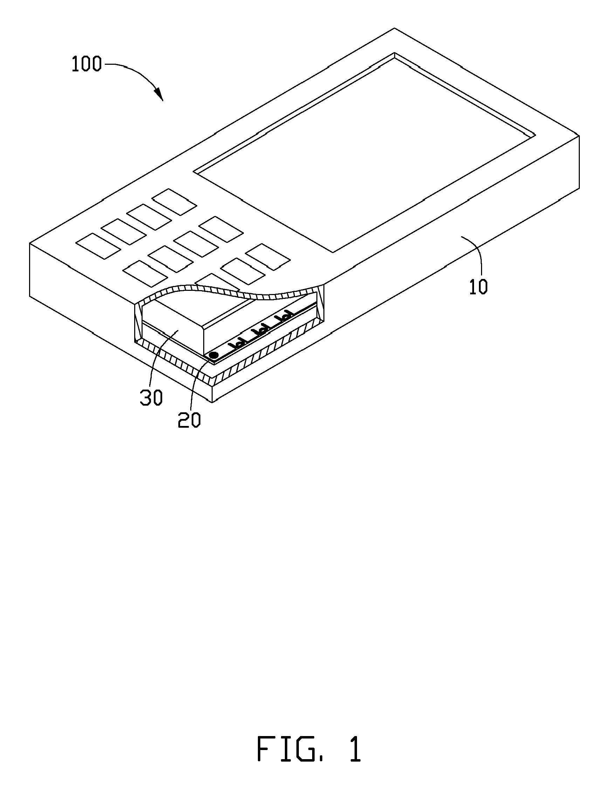

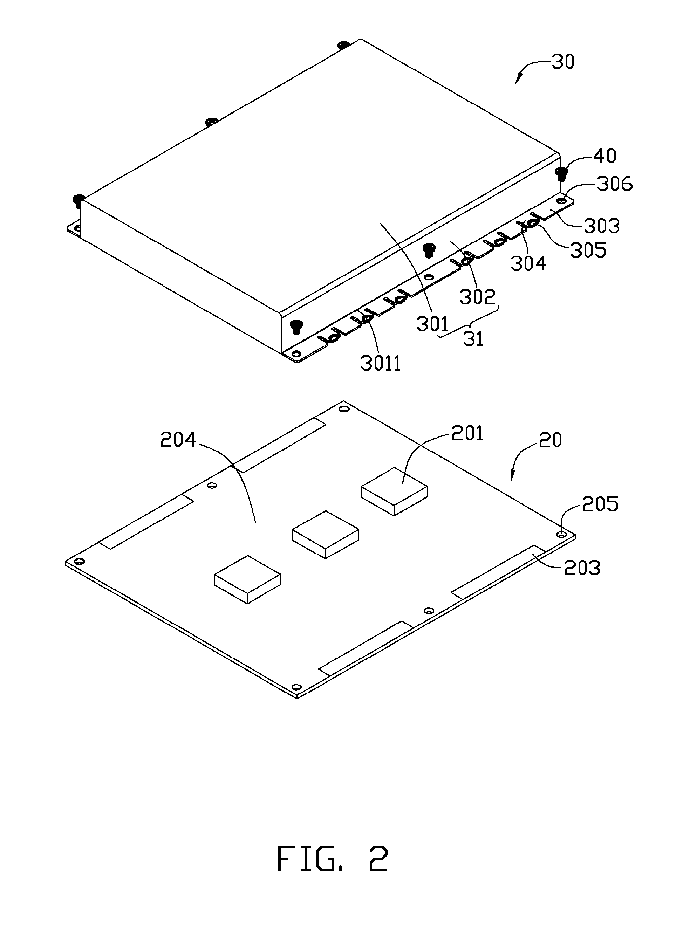

Referring to FIGs. 1 and 2, an exemplary electronic apparatus 100 includes a housing 10, and a PCB 20 and an electromagnetic shielding enclosure 30 both accommodated in the housing 10. The PCB 20 is rectangular, and includes a mounting region 204 having a plurality of electronic components 201 mounted thereon, and a grounding region 203. Additionally, the PCB 20 defines a plurality of blind screw holes 205 along a longitudinal edge thereof. Each of the grounding regions 203 is arranged between neighboring screw holes 205. The electromagnetic shielding enclosure 30 is mounted on the PCB 20 and encloses the electronic components 201. The electronic apparatus 100 can be a cell phone, an electronic game device, a portable computer, a digital camera and so on.

Referring to FIG.2, the electromagnetic shielding enclosure 30 includes a main body 31 consisting of a top panel 301, and a side panel 302 perpendicularly extending from edges of the top panel 301. In addition, the electromagnetic shielding enclosure 30 includes a plurality of fixing fins 303 and a plurality of resilient fins 304. The fixing fins 303 and the resilient fins 304 are arranged in an alternating fashion and perpendicularly extend out from a longitudinal edge 3011 of the side panel 302. The fixing fins 303 and the resilient fins 304 are spaced from but coplanar with each other and parallel to the top panel 301. The two extreme and the intermediate fixing fins 303 each define a through hole 306 aligned with a corresponding screw hole 205. Protrusions 305 are respectively formed on a distal end of each resilient fin 304, and configured to mechanically and electrically contact the electrically conductive region 203.

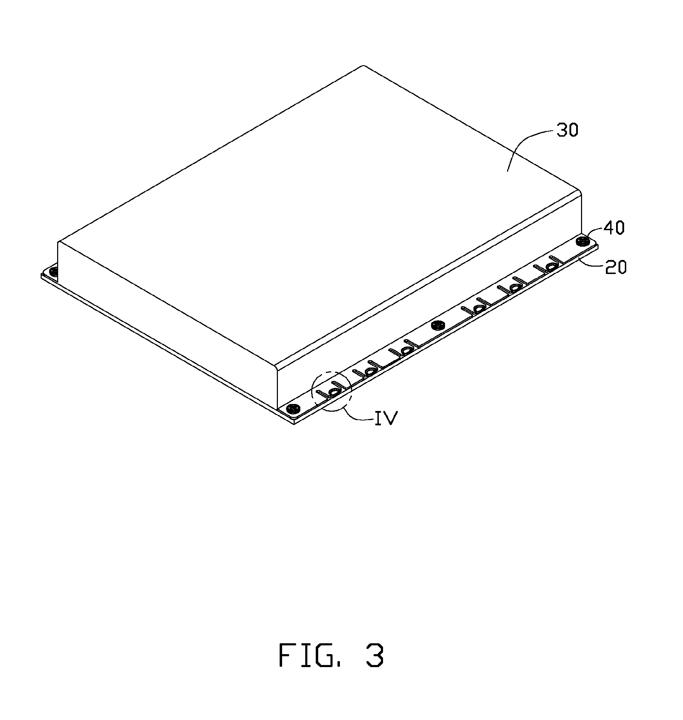

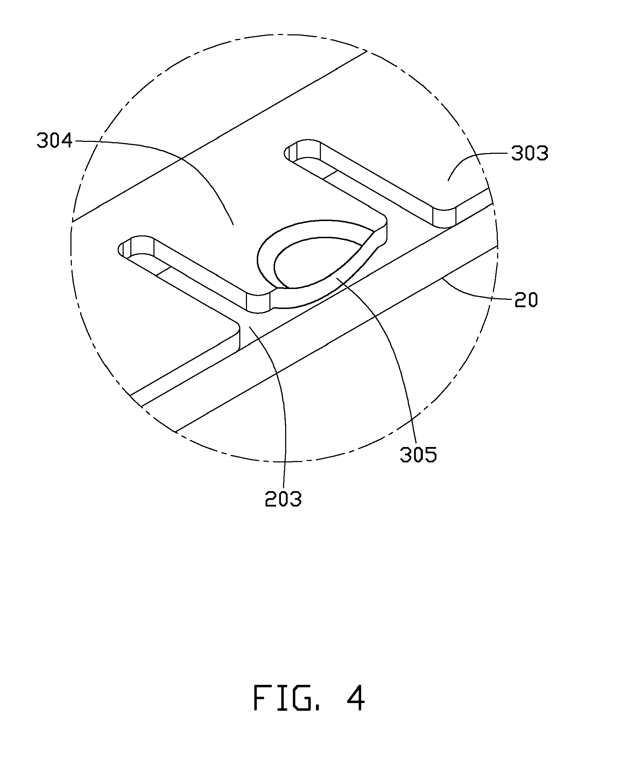

Referring to FIGs. 2-4, the electromagnetic shielding enclosure 30 is mounted on the PCB 20 with a plurality of screws 40 extending through the through hole 306 and screwed into the screwed holes 205. Once in place, the screws 40 apply a pressure onto the two extreme and intermediate fixing fins 303. Therefore, the resilient fins 304 slightly deform, such that the protrusions 305 directly contact with the electrically conductive regions 203. Hence, the electronic shielding enclosure 30 is properly grounded.

The above-described embodiments are intended to illustrate rather than limit the disclosure. Variations may be made to the embodiments and methods without departing from the spirit of the disclosure. Accordingly, it is appropriate that the appended claims be construed broadly and in a manner consistent with the scope of the disclosure.

## Claims

1. An electromagnetic shielding enclosure for mounting on a printed circuit board (PCB), the PCB comprising a grounding region and a mounting region having electronic components mounted thereon, the electromagnetic shielding enclosure comprising:
a main body including an edge;
a plurality of fixing fins; and
a plurality of resilient fins, the fixing fins and resilient fins extending from the edge of the main body, each of the resilient fins comprising a protrusion formed thereon, the fixing fins configured for being fixedly attached on the PCB in such a manner that the main body encloses the electronic components and the protrusions resiliently contact the grounding region.

2. The electromagnetic shielding enclosure of claim 1, wherein the fixing fins and the resilient fins are alternately arranged.

3. The electromagnetic shielding enclosure of claim 1 or claim 2, wherein the fixing fins and the resilient fins are spaced from but coplanar with each other.

4. The electromagnetic shielding enclosure of any preceding claim, further comprising a plurality of screws extending through the fixing fins to fix the main body on the PCB.

5. An electronic apparatus, comprising:
a PCB comprising a grounding region, a mounting region and a plurality of electronic components mounted on the mounting region; and
an electromagnetic shielding enclosure comprising:
a main body enclosing the electronic components;
a plurality of fixing fins; and
a plurality of resilient fins, the fixing fins and resilient fins extending from edges of the main body, each of the resilient fins comprising a protrusion formed thereon, the fixing fins being fixedly attached on the PCB and the protrusions resiliently contact the grounding region.

6. The electronic apparatus of claim 5, wherein the fixing fins and the resilient fins are alternately arranged.

7. The electronic apparatus of claim 5 or claim 6, wherein the fixing fins and the resilient fins are spaced from but substantially coplanar with each other.

8. The electronic apparatus of one of claims 5 to 7, further comprising a plurality of screws extending through the fixing fins to fix the main body on the PCB.

9. An electronic apparatus comprising:
a PCB comprising a grounding region, a mounting region and a plurality of electronic components mounted on the mounting region; and
an electromagnetic shielding enclosure attached on the PCB, the electromagnetic shielding enclosure comprising:
a main body receiving the electronic components therein, the main body including an edge;
a plurality of fixing fins;
a plurality of resilient fins, the fixing fins and the resilient fins extending from the edge, the fixing fins being fixedly attached on the PCB; and
a plurality of protrusions extending from the resilient fins and electrically touching the grounding region, the resilient fins being biased and slightly deformed by the protrusions.
